# EUROPÄISCHE PATENTSCHRIFT

(11) **EP 0 369 112 B1**
(45) Veröffentlichungstag und Bekanntmachung des Hinweises auf die Patenterteilung: **03.11.1993**
(21) Anmeldenummer: 89112853.0
(22) Anmeldetag: 13.07.1989
(51) Int. Cl.: G01R 1/073

(54) **Adapter für elektronische Prüfvorrichtungen für Leiterplatten und dgl.**
Adapter for electronic test devices for printed-circuit boards and the like
Adaptateur pour appareil électronique de contrôle des circuits imprimés et équipement semblable

(30) Priorität: 12.11.1988 DE 3838413
(43) Veröffentlichungstag der Anmeldung: 23.05.1990
(73) Patentinhaber: MANIA GmbH & Co., D-61276 Weilrod (DE)
(72) Erfinder: Mang, Paul, D-6384 Schmitten 3 (DE); Driller, Hubert, Dipl.-Phys., D-6384 Schmitten 3 (DE)
(74) Vertreter: Ruschke, Hans Edvard, Dipl.-Ing.

(56) Entgegenhaltungen:
- US-A- 4 571 542
- IBM TECHNICAL DISCLOSURE BULLETIN, vol. 21, no. 8, January 1979, page 3235

## Beschreibung

Die vorliegende Erfindung betrifft einen Adapter bzw. eine Kontaktanordnung zum Anschließen des regelmäßigen Grundrasters einer elektronischen Prüfvorrichtung für ein- oder mehrlagige plattenformige Verdrahtungsträger wie Leiterplatten, Keramiksubstrate und dergl. an die nicht notwendig rastergebundenen Kontakte/Anschlußpunkte des zu prüfenden Verdrahtungsträgers (Prüfling), die in Form von metallischen Kontaktflächen oder Anschlußbohrungen auf einer oder beiden Oberflächen des Prüflings vorliegen. Die Verdrahtungsträger sind bei der hier zur Debatte stehenden Prüfung in aller Regel noch nicht mit aktiven elektrischen/elektronischen Komponenten bestückt - es sei denn, es wird ein IC oder dergl. geprüft.

Derartige Kontaktanordnungen, vielfach auch "Adapter" oder englisch "test jig" genannt, sind in vielen verschiedenen Versionen bekannt, so u.a. aus der Literaturstelle "Patent Abstracts of Japan", Bd. 7, Nr. 278, (P-242) (1423), 10. Dezember 1983 und aus JP-A-58 155 374 vom 16.9.1983, oder aus IBM Technical Disclosure Bulletin, Bd. 24, Nr. 7A, Dez. 1981, Seiten 3342 bis 3344. Weitere derartige Anordnungen sind aus der GB-A-2 156 532, aus der US-A4 099 120 und der US-A-4 443 756 bekannt.

Darüber hinaus bringt die Firma ATG eine Kontaktanordnung auf den Markt, wie sie in etwa durch den Oberbegriff des Anspruches 1 als bekannt vorausgesetzt wird. Diese Kontaktanordnung besteht aus dem Grundkontaktfeld bzw. -raster der elektronischen Prüfvorrichtung (auf die nachfolgend nicht weiter eingegangen wird), aus einem darauf angeordneten aktiven Grundraster, welches aus entsprechend dem Grundkontaktraster angeordneten federnden Prüfstiften in einem isolierenden Grundrasterkörper besteht, auf die eine Adapterplatte aufgelegt wird, welche dazu dient, lokal erhöhte Anschlußdichten auf dem Prüfling und/oder den seitlichen Versatz (in X- und Y-Richtung dieser Platte) zwischen den regelmäßig angeordneten Kontakten entsprechend dem Grundraster und den nicht notwendig regelmäßig angeordneten Kontakten entsprechend der zu prüfenden Leiterplatte (Prüfling) auszugleichen. Dies geschieht, indem auf der einen Seite der Adapterplatte Kontaktflächen entsprechend dem Grundraster angeordnet sind, während auf der anderen Seite dieser Adapterplatte die dem Prüfling zugeordneten Kontaktflächen in identischer Anordnung wie auf dem Prüfling vorgesehen sind, wobei Leiterbahnen und Durchkontaktierungen auf bzw. in der Platte für die Verbindung der einander zugeordneten Kontaktflächen sorgen. An den dem Prüfling entsprechenden Kontaktflächen der Adapterplatte greifen dann wiederum vertikal angeordnete, in ihrer Längsrichtung federnde Prüfstifte an, auf deren Spitzen die Kontaktflächen des Prüflings durch eine geeignete Andruckvorrichtung aufgedrückt werden. Die hier in Rede stehenden Adapterplatten entsprechen in ihrem grundsätzlichen Aufbau den herkömmlichen gedruckten Leiterplatten (PCBs), wie sie geprüft werden sollen. Es handelt sich also um weitgehend starre bzw. biegesteife Platten aus Isolierstoffmaterial, die wie oben angedeutet auf der Ober- und Unterseite elektrisch leitfähige Kontaktflächen tragen. Eine derartige Kontaktanordnung mit einer starren Adapterplatte und daran angreifenden federnden Prüfstiften wird im Grundsatz in der Literaturstelle "IBM Technical Disclosure Bulletin", Vol. 21, Nr. 8, Januar 1979 auf Seite 3235 beschrieben.

Bei dieser bekannten und auf dem Markt befindlichen Anordnung ist es nachteilig, daß neben der ohnehin notwendigen individuellen Herstellung der Adapterplatte nach üblichen Leiterplattentechniken auch noch eine große Anzahl von federnden Prüfstiften erforderlich ist, deren Beschaffung für den Prüfgerätebenutzer eine erhebliche Investition darstellt, da diese Prüfstifte in recht großen Stückzahlen benötigt werden. Es kommt hinzu, daß aufgrund der notwendigen mechanischen Festigkeit solcher federnder Prüfstifte einer Miniaturisierung derselben und damit der zulässigen Kontakt- bzw. Prüfstiftdichte Grenzen gesetzt sind.

Diese Probleme können teilweise dadurch beseitigt werden, daß die Kontaktierung zwischen der einen Seite der Adapterplatte mit den dem Prüfling entsprechenden Kontaktflächen und dem Prüfling selbst durch eine sogenannte Vertikalleitplatte bewerkstelligt wird, die im Prinzip aus einer Platte aus elastischem isolierendem Material mit darin fein verteilten, parallel zueinander vertikal verlaufenden und somit gegeneinander isolierten Kontaktdrähten besteht, die an der Ober- und Unterseite aus der Oberfläche der Vertikalleitplatte herausragen. Mit Hilfe derartiger Vertikalleitplatten lassen sich die Adapterplatte und der Prüfling zwar verhältnismäßig problemlos verbinden, doch ist die Herstellung solcher Vertikalleitplatten außerordentlich teuer, wobei hinzukommt, daß die Verwendung einer solchen Kontaktierungstechnik durch in verschiedenen Ländern existierende gewerbliche Schutzrechte behindert werden könnte. In der weiteren Literaturstelle "IBM Technical Disclosure Bulletin, Vol. 20, Nr. 8, Januar 1978, S.2934 wird eine Kontaktanordnung ohne eine Adapterplatte beschrieben, die offenbar mit einer solchen Vertikalleiterplatte arbeitet. Eine ähnliche Anordnung mit einer allerdings nur durch Druck lokal elektrisch leitfähig werdenden Elastomermatte zeigt die US-A-4 571 542 von Arai.

Es ist daher die der vorliegenden Erfindung zugrundeliegende Aufgabe, die Probleme der oben angesprochenen Art durch eine neue Kontaktanordnung zu vermeiden. Diese Aufgabe wird in einer Ausführungsform der Erfindung dadurch gelöst, daß auf jeder Kontaktfläche auf mindestens einer Seite der Adapterplatte jeweils mindestens ein kissenartiger Pfropfen aus einem elektrisch leitfähigen federnden Elastomer angeordnet ist, der entweder fest mit der jeweiligen Kontaktfläche der Adapterplatte verbunden ist oder in einer an der Adapterplatte anliegenden Elastomermatte aus isolierendem Material gehaltert ist. Es ist also auf jede Kontaktfläche ein separates singuläres "Federkissen" aufgepfropft, das der einfachen Herstellbarkeit wegen aus dem genannten Elastomer besteht. Es ist aber an sich denkbar, an dieser Stelle stattdessen eine einfache mechanische Feder vorzusehen, auch wenn dies eine rationelle Fertigung erschweren oder unmöglich machen dürfte. In einer anderen Ausführungsform der Erfindung wird diese Aufgabe dadurch gelöst, daß die Adapterplatte mit den metallischen Kontaktflächen auf beiden Plattenoberflächen als dünne flexible Folie ausgebildet ist, die aufgrund ihrer Eigenflexibilität zum Ausgleich von möglichen vertikalen Kontakthöhenschwankungen in der Lage ist. In dem einen Fall werden also mögliche Kontakthöhenschwankungen an der Adapterplatte bzw. am Prüfling oder im Grundraster der Prüfvorrichtung dadurch ausgeglichen, daß die Adapterplatte im Bereich der metallischen Kontaktflächen einen kissenartigen Pfropfen aus flexiblem leitfähigem Elastomer aufweist, um so je nach Bedarf für einen federnden Ausgleich zu sorgen. Diese Alternative kann sowohl bei biegesteifen als auch bei flexiblen Adapterplatten Anwendung finden. In der anderen Ausführungsform der Erfindung wird der flexible Ausgleich zwischen unterschiedlichen Kontakthöhen einander gegenüberstehender Kontaktpunkte durch die Flexibilität der Adapterplatte selbst erreicht, die folienartig ausgebildet ist und sich daher aufgrund der Eigenflexibilität an unterschiedliche Kontakthöhen anpassen kann. Dabei weist eine solche folienartige Adapterplatte vorzugsweise, aber nicht notwendig auf wenigstens einer Seite in den Bereichen jeder Kontaktfläche einen Pfropfen aus dem federnden leitfähigen Elastomer auf. Noch zuverlässigere und unproblematischere Kontaktierungen ergeben sich dann, wenn das leitfähige Elastomer auf die Kontaktflächen auf beiden Seiten der folienartigen Adapterplatte aufgepfropft wird. In diesem Fall kann man auf ein gefedertes aktives Grundfeld verzichten und sich mit einem starren, d.h. ungefederten Grundrasterfeld begnügen, wie es die meisten Leiterplattenprüfvorrichtungen aufweisen. Eine Beschichtung der Kontaktflächen auf beiden Seiten der Adapterplatte bringt aber naturgemäß einen erhöhten Herstellungsaufwand mit sich.

In einer besonders bevorzugten Ausführungsform beider Lösungsmöglichkeiten der vorliegenden Erfindung wird zwischen der Adapterplatte und dem Grundraster der Prüfvorrichtung ein solches, an sich bekanntes aktives Grundraster in Form von einem Grundrasterkörper aus isolierendem Material und darin in parallelen Bohrungen entsprechend den Kontakten der Prüfvorrichtung angeordne ten, meist in Längsrichtung federnden Prüfstiften vorgesehen. Ein derartiges aktives Grundraster mit federnd gelagerten Kontakten erhöht die Kontaktsicherheit der Anordnung, weil gleichmäßigere Kontaktdrücke an allen Kontakten erreicht werden. Insbesondere bei zweiseitigem Prüfen der Prüflinge, d.h., wenn diese gleichzeitig auf ihren beiden Oberflächen von einer geeigneten Kontaktanordnung bzw. einem Adapter kontaktiert werden, ist es von besonderem Vorteil, wenn die jeweils verwendete Adapterplatte auf der dem Grundraster zugewandten Seite nicht nur von den federnden Prüfstiften des aktiven Grundrasters abgestützt wird, da es durch eine lokale Prüfpunktdichte auf der anderen Seite der Adapterplatte, nämlich dort, wo die Kontaktpunkte unregelmäßig verteilt sind, zu einer übermäßigen Belastung kommen kann, die den Prüfling verziehen bzw. beschädigen kann. Erfindungsgemäß wird daher der Grundrasterkörper des aktiven Grundrasters federnd ausgebildet, vorzugsweise aus einem federnden isolierenden Elastomer zur flächenhaften Abstützung der Adapterplatte gegen den Anpreßdruck des Prüflings aufgrund des Andruckmittels, und zwar in Ergänzung zur Abstützung der Adapterplatte durch die Prüfstifte des aktiven Grundrasters. Eine solche Ausgestaltung des aktiven Grundrasters ist insbesondere dann von Vorteil, wenn eine flexible folienartige Adapterplatte nach der zweiten Variante der vorliegenden Erfindung verwendet wird.

Das eigentliche elektronische Prüfgerät, auf das vorliegend nicht näher eingegangen wird, kann verschiedene Meßschaltungen aufweisen, um die Prüfroutine am Prüfling durchzuführen, der durch verschiedene Adaptierungstechniken an das Prüfgerät angeschlossen wird - so etwa durch die vorliegend erörterten Adaptierungstechniken. Nun kann es im Rahmen einer besonders genauen Meßschaltung des Prüfgerätes von Vorteil sein, wenn je nach Bedarf mindestens einem Prüfpunkt des Prüflings jeweils zwei Meßpunkte, d.h. Kontaktpunkte auf der Adapterplatte zugeordnet sind. Zu diesem Zweck kann im Rahmen der vorliegenden Erfindung vorgesehen werden, daß mindestens eine der dem Prüfling zugeordneten Kontaktflächen auf der einen Seite der Adapterplatte und die zugeordnete Kontaktfläche auf der anderen Seite der Adapterplatte in zwei voneinander isolierte Teile geteilt sind, die jeweils mit dem entsprechenden Teil auf der anderen Seite der Adapterplatte elektrisch verbunden sind. Durch eine solche Ausgestaltung der Adapterplatte wird der entsprechend ausgestattete Meß- bzw. Kontaktpunkt im Rahmen einer sogenannten "Kelvin-Meßschaltung" brauchbar, auf die im vorliegenden Rahmen jedoch nicht eingegangen wird.

Als leitfähiger federnder Elastomer wird für die Zwecke der vorliegenden Adaptierungstechnik ein Silikongummi mit darin fein verteilten Metallpartikeln bevorzugt. Allerdings sind im Stand der Technik auch andere leitfähige federnde Elastomere wie kohlenstoffangereicherte Polyurethane bekannt, die hier Verwendung finden können.

Durch die erfindungsgemäße Ausgestaltung der Adapterplatte können Dickenschwankungen des Prüflings in der Größenordnung von bis zu 200 µm "lokal", d.h. zwischen benachbarten Kontaktpunkten und bis zu 500 µm "global" ausgeglichen werden, d.h. über Strecken auf der Leiterplatte von ca. 20 - 30 cm.

Ein ganz wesentlicher Vorteil bei der vorliegenden Erfindung besteht darin, daß die im Stand der Technik von den gefederten Prüfstiften und/oder dem aktiven Grundraster erzeugte federnde Nachgiebigkeit zum Ausgleich von Dicken- und Kontakthöhenschwankungen in den Bereich der Adapterplatte verlegt wird, die entweder durch die aufgebrachten Pfropfen aus leitfähigen elastomerem Material oder durch die Eigenflexibilität der folienartigen Adapterplatte erreicht wird. Damit entfällt die Notwendigkeit von Prüfstiften d.h. es wird ein "prüfstiftloser" Adapter vorgesehen.

Die Herstellung der je nach zu testendem Prüfling (diese können z.B. mehrlagig oder zweiseitig sein) unterschiedlichen Adapterplatten erfolgt nach den für die Herstellung herkömmlichen Leiterplatten üblichen Techniken beim Prüfgerätbenutzer selbst, der in der Regel ein Leiterplattenhersteller sein wird. Die dabei benötigten Photomasken und/oder Bohrprogramme etc. können dabei wie im Stand der Technik mit Hilfe von elektronischer Datenverarbeitung (CAD-Techniken und NC-Bohrmaschinen) erstellt werden. Das Aufbringen der Pfropfen aus dem leitfähigen Elastomer auf die Kontaktflächen der in üblicher Leiterplattentechnik hergestellten Adapterplatte oder das Einbringen in die Bohrungen der Elastomermatte aus isolierendem Material geschieht ebenfals mittels bekannter Techniken, beispielsweise im Wege des Siedbruckes oder mittels geeigneter Spritztechniken, wobei der Elastomer in noch flüssiger Form verarbeitet wird.

Verschiedene Ausführungsformen der Erfindung werden nachfolgend unter Bezugnahme auf die beigefügten Zeichnungen beschrieben. Darin zeigt:
- Fig. 1: eine erfindungsgemäße Kontaktanordnung in prinzipieller Darstellung, wobei ein einseitig mit Kontaktflächen versehener Verdrahtungsträger geprüft wird;
- Fig. 2: zwei verschiedene Ausführungsformen der Kontaktanordnung, wobei ein beidseitig mit Kontaktflächen/Anschlußpunkten versehener Verdrahtungsträger gleichzeitig von beiden Seiten geprüft wird, und zwar in der oberen Hälfte der Figur von einer anderen Ausführungsform als in der unteren Hälfte ; und
- Fig. 3: eine weitere Ausführungsform der Kontaktanordnung, bei der die Pfropfen aus elektrisch leitfähigem Elastomer von den Kontaktflächen der Adapterplatte losgelöst in separaten Kontaktmatten angeordnet sind.

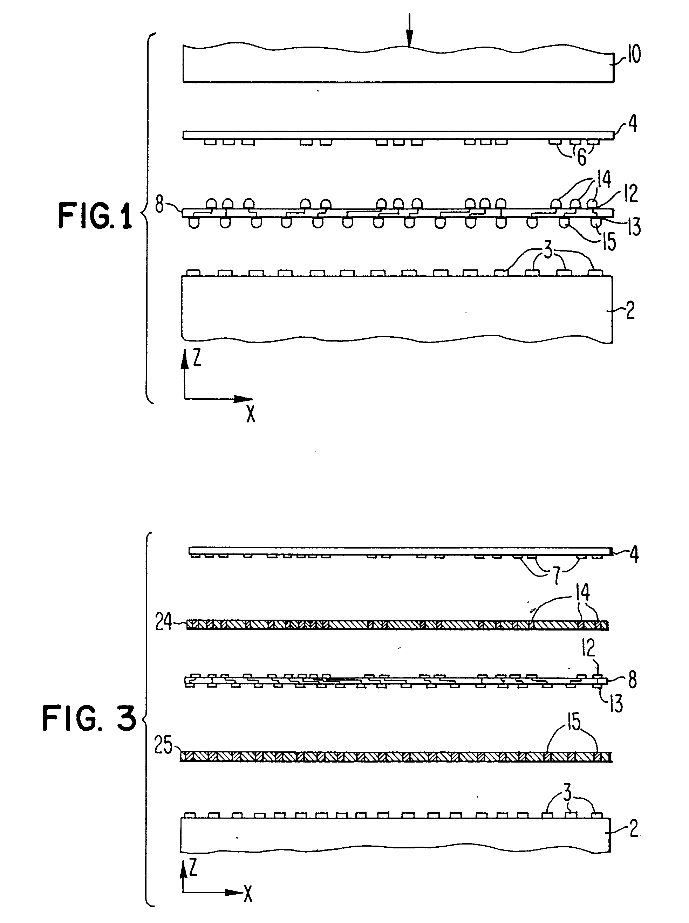

Die Figuren 1, 2 und 3 zeigen die erfindungsgemäßen Kontaktanordnungen in einer Darstellung, in der die einzelnen Elemente in senkrechter Richtung, d.h. in Richtung der Z-Achse des eingezeichneten Koordinatenkreuzes auseinandergezogen sind, um die Verhältnisse besser zeigen zu können. Zudem sei angemerkt, daß es sich bei den dargestellten Elementen um dreidimensionale Gebilde handelt, wobei jedoch die Darstellung nur in der X-Z-Ebene, d.h. der Zeichenebene, erfolgt und die dritte Dimension der Y-Koordinate senkrecht zur Zeichenebene verläuft und nicht dargestellt ist.

Das Bezugszeichen 2 bezeichnet ein übliches Leiterplattenprüfgerät mit einem regelmäßigen Grundraster 3 aus Kontaktpunkten zum Anschluß der nicht rastergebundenen Kontakte oder Anschlußpunkte 6 des Prüflings 4 mit Hilfe der erfindungsgemäßen, nachfolgend zu beschreibenden Adaptierungstechnik. Die Kontaktflächen oder Anschlußpunkte 6 auf dem Verdrahtungsträger 4 (Leiterplatte Keramiksubstrat etc.) sind, wie in der Leiterplattenindustrie üblich, nahezu beliebig angeordnet, d.h., sie können beispielsweise teilweise rastergebunden und teilweise örtlich verdichtet etc. auf der zu prüfenden Leiterplatte 4 angeordnet sein, und zwar oft mit vielen hunderten oder gar tausenden von Anschlußpunkten 6 pro Leiterplatte/Verdrahtungsträger 4. Um diese unregelmäßig angeordneten Anschlußpunkte mit den regelmäßig angeordneten Kontakten des Grundrasters 3 der Prüfvorrichtung 2 zu verbinden, ist in der Fig. 1 eine Adapterplatte 8 genannte Platte vorgesehen, die nach den üblichen Leiterplattentechniken als gedruckte Schaltung mit Kontaktflächen 12 und 13 auf den beiden Seiten der Adapterplatte individuell, also je nach zu prüfendem Verdrahtungsträger hergestellt werden muß. Dabei sind die der Prüfvorrichtung 2 zugewandten Kontaktflächen 13 genau entsprechend dem Grundraster 3 der Prüfvorrichtung angeordnet, während die Kontaktflächen 12 auf der dem Prüfling zugewandten Seite der Adapterplatte 8 entsprechend der Anordnung der Anschlußpunkte 6 des Prüflings 4 verteilt sind. Dabei ist jede Kontaktfläche 12 mit einer zugeordneten Kontaktfläche 13 auf der anderen Seite der Adapterplatte 8 verbunden, und zwar nach üblichen Leiterplattentechniken mit Hilfe von (in der Zeichnung nicht dargestellten) Leiterbahnen auf einer der beiden Oberflächen der Adapterplatte sowie Durchkontaktierungen, d.h. in Richtung der Z-Achse sich erstreckenden, also senkrecht zur Adapterplatte verlaufenden leitenden Bereichen in der Adapterplatte, so daß der Prüfstrom der Prüfvorrichtung von einem Kontakt des Grundrasters 3 zu der zugehörigen Kontaktfläche 13 auf der einen Seite der Adapterplatte und weiter zur anderen Kontaktfläche 12 auf der anderen Seite der Adapterplatte und von dort zu dem zu prüfenden Anschlußpunkt 6 des Prüflings 4 fließen kann.

Um nun für einen gleichmäßigen Kontaktdruck und somit eine ordnungsgemäße Kontaktierung des Prüflinges an sämtlichen Prüfkontakten/Kontaktflächen der Kontaktanordnung zu sorgen, wird in der Ausführungsform der Fig. 1 vorgesehen, daß auf jeder Kontaktfläche 12 bzw. 13 der Adapterplatte 8 ein Pfropfen 14 bzw. 15 aus einem elektrisch leitfähigen Elastomer angeordnet wird. Diese Pfropfen sind elastisch zusammendrückbar, so daß sie für den notwendigen Kontaktdruck zwischen dem Prüfling 4 und dem Grundraster 3 bzw. für den Ausgleich von eventuellen Kontakthöhenschwankungen sorgen, die sich stets aufgrund von Zufälligkeiten oder Produktionsungenauigkeiten etc. einstellen. Der notwendige Anpreßdruck zwischen dem Prüfling 4, der Adapterplatte 8 mit den Pfropfen 14 und 15 auf allen Kontaktflächen 12, 13 und dem Grundraster 3 des Prüfgerätes wird im Fall der Ausführungsform nach Fig. 1 durch eine biegesteife Andruckplatte 10 bewerkstelligt, die Teil einer hydraulischen Presse oder dergleichen sein kann.

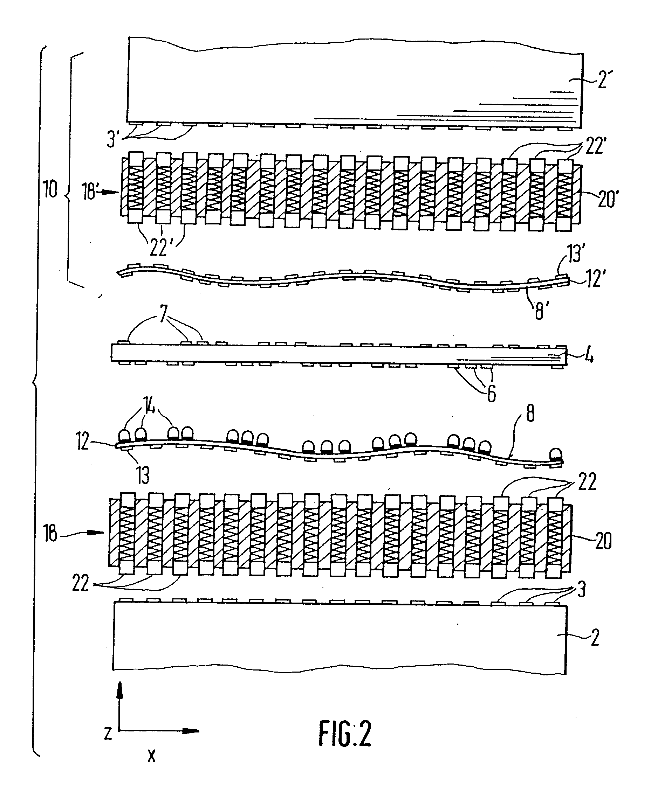

In der Fig. 1 ist die Adapterplatte 8 eine im wesentlichen in sich biegesteife Leiterplatte, während in der grundsätzlich ähnlichen Darstellung der Fig. 2 die entsprechenden Adapterplatten 8, 8' folienartig dünn sind und daher leicht gewellt dargestellt sind, d.h. die in der oberen Hälfte der Fig. 2 gezeigte Adapterplatte/-folie 8' ist in der Lage, allein aufgrund ihrer Eigenflexibilität sehr weitgehend Kontakthöhenschwanungen in der Z-Richtung am Prüfling 4 auszugleichen. Für den entsprechenden Kontakthöhenausgleich zwischen den Kontaktflächen 13 dieser Adapterfolie 8' und der zweiten (oberen) Prüfvorrichtung 2' sorgt ein sogenanntes aktives Grundraster 18' (sofern notwendig), auf das weiter unten noch näher eingegangen wird. Diese Fig. 2 zeigt wiederum in grundsätzlicher Darstellung die gleichzeitige beidseitige Prüfung eines Prüflings 4, wobei in der unteren Hälfte eine etwas abgewandtelte Adaptierungstechnik an der Adapterplatte/-folie 8 verwendet wird, wobei die Adaptierungstechnik in der unteren Bildhälfte der Fig. 2 stärker an diejenige der Fig. 1 angelehnt ist. Soweit in den Fig. 1 und 2 gleiche Elemente vorhanden sind, werden auch gleiche Bezugszeichen verwendet, wobei jedoch die Bezugszeichen der oberen Hälfte der Fig. 2 mit einem zusätzlichen Beistrich versehen sind.

Die Adapterfolie 8 der unteren Hälfte der Fig. 2 weist nur auf der dem Prüfling 4 zugewandten Seite auf den jeweiligen Kontaktflächen 12 Pfropfen 14 aus elektrisch leitfähigem Elastomer auf, wobei diese Pfropfen 14 zusätzlich zum aktiven Grundraster 18 für einen besonders guten Kontakthöhenausgleich in Richtung der Z-Achse sorgen.

Abgesehen von einer Besonderheit, auf die später eingegangen wird, handelt es sich bei dem aktiven Grundraster um ein bekanntes Bauteil, welches auf die unverschieblich gelagerten Kontakte des Grundrasters 3 der Prüfvorrichtung 2 aufgesetzt wird, um aus dem starren Grundraster 3 ein in der Z-Richtung "aktiv" federndes Grundraster mit den Prüfkontakten 22 bereitzustellen. Das aktive Grundraster 18 kann beispielsweise in der Weise dergestellt werden, daß ein nichtleitender elektrischer Grundkörper 20 mit vielen in der Z-Richtung und parallel zueinander verlaufenden Bohrungen entsprechend der Verteilung des Grundrasters 3 versehen wird, wobei in diese Bohrungen dann federnde Prüfstifte von passender Länge eingesetzt werden. Die den Adapterplatten 8 bzw. 8' zugewandten Spitzen dieser federnden Prüfstifte entsprechen dann den Prüfkontakten 22 bzw. 22' des aktiven Grundrasters 18 bzw. 18'.

Das aktive Grundraster 18 bzw. 18' ist insofern in besonderer Weise ausgesbildet, als der Grundrasterkörper 20 bzw. 20' aus einem in sich elastischen Material hergestellt ist, also zum Beispiel aus einem elektrisch nichtleitenden Elastomer. Wenn die Elastizität des Grundrasterkörpers in etwa der Elastizität der Lagerung der Kontakte 22 entspricht, dann trägt der Grundrasterkörper 20 dazu bei, den Prüfling bzw. Verdrahtungsträger 4 während des Aufbringens des Kontaktdruckes großflächig, d.h. nicht nur im Bereich der Kontaktflächen abzustützen. Dies ist insbesondere dann von Vorteil, wenn der Prüfling 4 sehr stark unregelmäßig angeordnete Anschlußpunkte 6 und 7 aufweist, die in großer Zahl vorhanden sein können. Denn wenn es keine derartige großflächige Abstützung für den Prüfling 4 gäbe, könnte es wegen der örtlichen Konzentration des Anpreßdruckes ausschließlich über die Anschlußpunkte 6, 7 des Prüflings 4 zu einem Beschädigen oder Zerreißen des Prüflings 4 oder der darauf vorhandenen Leiterbahnen kommen.

Durch das Bezugszeichen 10 in der oberen Hälfte der Fig. 2 soll angedeutet werden. daß die obere Anordnung aus Prüfvorrichtung 2′, aktivem Grundraster 18′ und Adapterplatte 8′ wie die Andruckplatte 10 in Fig. 1 wirkt. Wenn also eine gleichzeitige beidseitige Prüfung einer Leiterplatte 4 erfolgen soll, dann muß das Grundraster 3′ der Prüfvorrichtung 2′ zusammen mit dem aktiven Grundraster 18′ und der Adapterplatte/-folie 8′ in der gleichen Weise in der Z-Richtung beweglich gelagert werden, wie dies bei der Andruckplatte 10 mit Hilfe einer nicht näher dargestellten hydraulischen Vorrichtung geschieht.

Die Fig. 3 zeigt eine Abwandlung der Kontaktanordnungen nach den Figuren 1 und 2. Hierbei sind die den Kontaktflächen 12 und 13 zugeordneten Pfropfen 14 und 15 aus dem elektrisch leitfähigen Elastomermaterial nicht fest mit den Kontaktflächen der Adapterplatte verbunden, sondern sind losgelöst davon in einer separaten Kontaktmatte angeordnet, die aus einem elektrisch isolierenden elastomeren Material hergestellt ist.

## Patentansprüche

1. Kontaktanordnung zum Anschließen des regelmäßigen Grundrasters (3) einer elektronischen Prüfvorrichtung (2) für ein- oder mehrlagige plattenförmige Verdrahtungsträger (4) wie Leiterplatten, Keramiksubstrate und dergl. an die nicht notwendig rastergebundenen Kontakte/Anschlußpunkte (6) des zu prüfenden Prüflings/Verdrahtungsträgers (4), die in Form von metallischen Kontaktflächen oder -pads auf einer oder beiden Oberflächen des Prüflings vorliegen,
- mit einer zwischen dem Grundraster der Prüfvorrichtung und dem Prüfling angeordneten Adapterplatte (8) in Form einer durchkontaktierten Leiterplatte mit metallischen Kontaktflächen (12, 13) auf beiden Plattenoberseiten und Leiterbahnen zum Ausgleich lokal erhöhter Anschlußdichten auf dem Prüfling und/oder des möglicherweise vorhandenen seitlichen Versatzes (in X- bzw. Y-Richtung des Prüflings) zwischen dem regelmäßigen Grundraster (3) und den variabel angeordneten Anschlußpunkten (6) des Prüflings (4),
- mit federnden Kontaktmitteln zwischen dem Prüfling und der Adapterplatte (8) zum Ausgleich möglicher vertikaler Kontakthöhenschwankungen in Z-Richtung des Prüflings
- und mit einem plattenförmigen, formstabilen Andruckmittel (10) zur Erzeugung eines ausreichenden Kontaktdruckes an allen Kontakten der Kontaktanordnung,
dadurch gekennzeichnet,
daß auf jeder Kontaktfläche (12; 13) auf mindestens einer Seite der Adapterplatte (8) jeweils mindestens ein kissenartiger Pfropfen (14; 15) aus einem elektrisch leitfähigen federnden Elastomer angeordnet ist, wobei der Pfropfen einer jeden Kontaktfläche gegenüber dem Pfropfen einer jeder benachbarten Kontaktfläche elektrisch isoliert angeordnet ist.

2. Kontaktanordnung nach Anspruch 1, dadurch gekennzeichnet, daß die Pfropfen (14, 15) auf den Kontaktflächen (12 und/oder 13) der Adapterplatte (8) jeweils fest mit den Kontaktflächen (12 und/oder 13) verbunden sind.

3. Kontaktanordnung nach Anspruch 1, dadurch gekennzeichnet, daß die Pfropfen (14 und/oder 15) aus elektrisch leitfähigem federnden Elastomer auf einer oder beiden Seiten der Adapterplate (8) von Matten (24, 25) aus einem isolierenden federnden Elastomer gehaltert werden, die zwischen der Adapterplatte (8) und dem Prüfling (4) und/oder der Adapterplatte (8) und dem Grundrasterfeld (3 oder 18) angeordnet sind.

4. Kontaktanordnung nach einem der voranstehenden Ansprüche, dadurch gekennzeichnet, daß die Adapterplatte (8) folienartig, in sich flexibel ausgebildet ist.

5. Kontaktanordnung nach einem der voranstehenden Ansprüche 1 bis 3, dadurch gekennzeichnet, daß die Adapterplatte (8) im wesentlichen biegesteif ist.

6. Kontaktanordnung zum Anschließen des regelmäßigen Grundrasters (3) einer elektronischen Prüfvorrichtung (2) für ein- oder mehrlagige plattenförmige Verdrahtungsträger (4) wie Leiterplatten, Keramiksubstrate und dergl. an die nicht notwendig rastergebundenen Kontakte/Anschlußpunkte (6, 7) des zu prüfenden Verdrahtungsträgers bzw. Prüflings, die in Form von metallischen Kontaktflächen oder -pads auf einer oder beiden Oberflächen des Prüflings (4) vorliegen,
- mit einer zwischen dem Grundraster (3) der Prüfvorrichtung (2) und dem Prüfling (4) angeordneten Adapterplatte (8) in Form einer durchkontaktierten Leiterplatte mit metallischen Kontaktflächen (12; 13) auf beiden Plattenoberseiten und Leiterbahnen zum Ausgleich lokal erhöhter Anschlußdichten auf dem Prüfling und/oder des möglicherweise vorhandenen seitlichen Versatzes in X- bzw. Y-Richtung des Prüflings zwischen dem regelmäßigen Grundraster (3) und den variabel angeordneten Anschlußpunkten des Prüflings,
- mit federnden Kontaktmitteln zum Ausgleich möglicher vertikaler Kontakthöhenschwankungen (in Z-Richtung des Prüflungs
- und mit einem plattenförmigen, formstabilen Andruckmittel (10) zur Erzeugung eines ausreichenden Kontaktdruckes an allen Kontakten der Kontaktanordnung,
dadurch gekennzeichnet,
daß die Adapterplatte (8) mit den metallischen Kontaktflächen (12; 13) auf beiden Plattenoberseiten als dünne, flexible Folie ausgebildet ist, die aufgrund ihrer Eigenflexibilität zum Ausgleich von möglichen vertikalen Kontakthöhenschwankungen in Z-Richtung des Prüflings zwischen dem Prüfling (4) und der Adapterplatte (8) in der Lage ist.

7. Kontaktanordnung nach einem der Ansprüche 1 bis 6, mit einem zwischen der Adapterplatte (8) und dem starren Grundraster (3) der Prüfvorrichtung (2) angeordneten aktiven Grundraster (18) in Form von einem Grundrasterkörper (20) aus isolierendem Material und darin entsprechend dem Grundraster (3) der Prüfvorrichtung (2) angeordneten, in Z-Richtung des Prüflings federnden Prüfkontakten, dadurch gekennzeichnet, daß der Grundrasterkörper (20) des aktiven Grundrasters (18) in sich federnd aus einem federnden Elastomer ausgebildet ist zur flächenhaften Abstützung der Adapterplatte (8) gegen den Anpreßdruck des Prüflings (4) aufgrund des Andruckmittels (10) in Ergänzung zur Abstützung der Adapterplatte (8) durch die federnden Prüfkontakte (22) des aktiven Grundrasters (18).

8. Kontaktanordnung nach Anspruch 6 oder 7, dadurch gekennzeichnet, daß auf jeder Kontaktfläche auf mindestens einer Seite der Adapterplatte zusätzlich ein Pfropfen aus dem leitfähigen, federnden Elastomer angeordnet ist.

9. Kontaktanordnung nach einem der voranstehenden Ansprüche, dadurch gekennzeichnet, daß mindestens eine der dem Prüfling zugeordneten Kontaktflächen auf der einen Seite der Adapterplatte und die zugeordnete Kontaktfläche auf der anderen Seite der Adapterplatte in zwei voneinander isolierte Teile geteilt sind, die jeweils mit dem entsprechenden Teil auf der anderen Seite der Adapterplatte elektrisch verbunden sind.

10. Kontaktanordnung nach einem der voranstehenden Ansprüche, dadurch gekennzeichnet, daß der leitfähige federnde Elastomer ein Silikongummi mit darin fein verteilten Metallpartikeln ist.

## Claims

1. Contact arrangement for the connection of the regular basic grid (3) of an electronic testing device (2) for single- or multi-layer flat wiring carriers (4) such as circuit boards, ceramic substrates and similar, to the not necessarily grid-linked contacts/connection points (6) of the test specimen/wiring carrier (4) to be tested, existing in the form of metal contact areas or pads on one or both surfaces of the test specimen,
- with an adapter board (8) arranged between the basic grid of the testing device and the test specimen, in the form of a plated through hole circuit board with metal contact areas (12, 13) on both sides of the board and conductor tracks to equalise locally raised connection densities on the test specimen and/or possible sideways displacement (in the X or Y direction of the test specimen) between the regular basic grid (3) and the variably arranged connection points (6) of the test specimen (4).
- with springy contact media between the test specimen and the adapter board (8) to equalise possible vertical contact height variations in the Z direction of the test specimen
- and with a flat, dimensionally stable pressure medium (10) to create adequate contact pressure on all contacts in the contact arrangement
characterised by
the fact that on each contact area (12; 13) on at least one side of the adapter board (8) at least one cushion-like plug (14; 15) made from an electrically conductive springy elastomer is arranged, and the plug on each contact area is electrically insulated from the plug of each neignbouring contact area.

2. Contact arrangement as in claim 1, characterised by the fact that the plugs (14, 15) on the contact areas (12 and/or 13) of the adapter board (8) are each permanently fixed to the contact areas (12 and/or 13).

3. Contact arrangement as in claim 1, characterised by the fact that the plugs (14 and/or 15) made from electrically conductive springy elastomer are held by mats (14, 15) made from an insulating springy elastomer on one or both sides of the adapter board (8), arranged between the adapter board (8) and the test specimen (4) and/or the adapter board (8) and the basic grid area (3 or 18).

4. Contact arrangement as in one of the above claims, characterised by the fact that the adapter board (8) is constructed flexibly, like a film.

5. Contact arrangement as in one of the above claims 1 to 3, characterised by the fact that the adapter board (8) is essentially semi-rigid.

6. Contact arrangement for the connection of the regular basic grid (3) of an electronic testing device (2) for single- or multi-layer flat wiring carriers (4) such as circuit boards, ceramic substrates and similar to the not necessarily grid-linked contacts/connection points (6) of the test specimen/wiring carrier (4) to be tested, existing in the form of metal contact areas or pads on one or both surfaces of the test specimen,
- with an adapter board (8) arranged between the basic grid of the testing device and the test specimen, in the form of a plated through hole circuit board with metal contact areas (12, 13) on both sides of the board and conductor tracks to equalise locally raised connection densities on the test specimen and/or possible sideways displacement (in the X or Y direction of the test specimen) between the regular basic grid (3) and the variably arranged connection points (6) of the test specimen (4).
- with springy contact media to equalise possible vertical contact height variations in the Z direction of the test specimen
- and with a flat, dimensionally stable pressure medium (10) to create adequate contact pressure on all contacts in the contact arrangement
characterised by
the fact that the adapter board (8) with metal contact areas (12; 13) on both sides of the board is constructed as a thin, flexible film, which, on the basis of its inherent flexibility, is in a position to equalise possible vertical variations in contact height in the Z direction of the test specimen between the test specimen (4) and the adapter board (8).

7. Contact arrangement as in one of claims 1 to 6, with an active basic grid (18) arranged between the adapter board (8) and the rigid basic grid (3) of the testing device (2), which is in the form of a basic grid body (20) made from insulating material and springy test contacts in the Z direction of the test specimen arranged to correspond to the basic grid (3) of the testing device (2), characterised by the fact that the basic grid body (3) of the active basic grid (18) is formed from a springy elastomer to support the adapter board (8) over its entire area against the pressure from the test specimen (4) resulting from the means of applying pressure (10), in addition to the support given to the adapter board (8) by the sprung test contacts (22) of the active basic grid (18).

8. Contact arrangement as in Claim 6 to 7, characterised by the fact that on each contact area on at least one side of the adapter board there is additionally one plug made from conductive springy elastomer.

9. Contact arrangement as in one of the above Claims, characterised by the fact that at least one of the contact areas allocated to the test specimen on one side of the adapter board and the allocated contact area on the other side of the adapter board are divided into two parts insulated from one another, each electrically connected to the corresponding part on the other side of the adapter board.

10. Contact arrangement as in one of the above Claims, characterised by the fact that the conductive springy elastomer is a silicone rubber containing finely distributed metal particles.

## Revendications

1. Dispositif de contact pour la connexion de la grille fondamentale régulière (3) d'un dispositif électronique de contrôle (2) pour supports de câblage en forme de plaque monocouches ou multicouches (4) tels que cartes imprimées, substrats en céramique et éléments semblables aux contacts ou points de connexion (6), non nécessairement sur la grille, du spécimen ou support de câblage (4) à contrôler, qui se présentent sous la forme de surfaces ou pads de contact métalliques sur une face ou les deux faces du spécimen, comportant
- une plaque adaptatrice (8) placée entre la grille fondamentale du dispositif de contrôle et le spécimen et formée d'une carte imprimée à contacts traversants ayant des surfaces de contact métalliques (12, 13) sur ses deux faces et des chemins conducteurs pour la compensation de densités de connexion localement élevées sur le spécimen et/ou du décalage latéral existant éventuellement (dans la direction X ou la direction Y du spécimen) entre la grille fondamentale régulière (3) et les points de connexion (6) disposés de manière variable du spécimen (4),
- des moyens de contact élastiques entre le spécimen et la plaque adaptatrice (8) pour la compensation des variations verticales possibles de hauteur des contacts dans la direction Z du spécimen, et
- un moyen de ser rage de forme stable en forme de plaque (10) pour la production d'une pression de contact suffisante à tous les contacts du dispositif de contact,
caractérisé par le fait que sur chaque surface de contact (12 ; 13) sur au moins une face de la plaque adaptatrice (8) est placé au moins un tampon du genre coussin (14 ; 15) en élastomère élastique conducteur, le tampon de chaque surface de contact étant isolé électriquement du tampon de chaque surface de contact voisine.

2. Dispositif de contact selon la revendication 1, caractérisé par le fait que les tampons (14, 15) placés sur les surfaces de contact (12 et/ou 13) de la plaque adaptatrice (8) sont fixés à ces surfaces (12 et/ou 13).

3. Dispositif de contact selon la revendication 1, caractérisé par le fait que les tampons (14 et/ou 15) en élastomère élastique conducteur placés sur une face ou les deux faces de la plaque adaptatrice (8) sont supportés par des nattes (24, 25) en élastomère élastique isolant placées entre la plaque adaptatrice (8) et le spécimen (4) et/ou la plaque adaptatrice (8) et la grille fondamentale (3 ou 18).

4. Dispositif de contact selon l'une des revendications précédentes, caractérisé par le fait que la plaque adaptatrice (8) est du genre feuille et souple.

5. Dispositif de contact selon l'une des revendications 1 à 3, caractérisé par le fait que la plaque adaptatrice (8) est pratiquement rigide à la flexion.

6. Dispositif de contact pour la connexion de la grille fondamentale régulière (3) d'un dispositif électronique de contrôle (2) pour supports de câblage en forme de plaque monocouches ou multicouches (4) tels que cartes imprimées, substrats en céramique et éléments semblables aux contacts ou points de connexion (6, 7), non nécessairement sur la grille, du support de câblage ou spécimen à contrôler, qui se présentent sous la forme de surfaces ou pads de contact métalliques sur une face ou les deux faces du spécimen (4), comportant
- une plaque adaptatrice (8) placée entre la grille fondamentale (3) du dispositif de contrôle (2) et le spécimen (4) et formée d'une carte imprimée à contacts traversants ayant des surfaces de contact métalliques (12 ; 13) sur ses deux faces et des chemins conducteurs pour la compensation de densités de connexion localement élevées sur le spécimen et/ou du décalage latéral existant éventuellement (dans la direction X ou la direction Y du spécimen) entre la grille fondamentale régulière (3) et les points de connexion disposés de manière variable du spécimen,
- des moyens de contact élastiques pour la compensation des variations verticales possibles de hauteur des contacts dans la direction Z du spécimen entre celui-ci et la plaque adaptatrice (8), et
- un moyen de serrage de forme stable en forme de plaque (10) pour la production d'une pression de contact suffisante à tous les contacts du dispositif de contact,
caractérisé par le fait que la plaque adaptatrice (8) portant les surfaces de contact métalliques (12 ; 13) sur ses deux faces est constituée d'une feuille mince souple qui, en raison de sa souplesse propre, est capable de compenser les variations verticales possibles de hauteur des contacts dans la direction Z du spécimen entre celui-ci et elle.

7. Dispositif de contact selon l'une des revendications 1 à 6, comportant une grille fondamentale active (18) placée entre la plaque adaptatrice (8) et la grille fondamentale rigide (3) du dispositif de contrôle (2) et formée d'un corps de base (20) en matière isolante et de contacts de test élastiques dans la direction Z du spécimen placés dans ce corps de base (20) de manière correspondant à la grille fondamentale (3) du dispositif de contrôle (2), caractérisé par le fait que le corps de base (20) de la grille fondamentale active (18) est constitué d'un élastomère élastique pour le support suivant une surface de la plaque adaptatrice (8) contre la pression de serrage du spécimen (4) produite par le moyen de serrage (10) en complément du support de la plaque adaptatrice (8) par les contacts de test élastiques (22) de la grille fondamentale active (18).

8. Dispositif de contact selon l'une des revendications 6 et 7, caractérisé par le fait que sur chaque surface de contact sur au moins une face de la plaque adaptatrice est placé en plus un tampon en élastomère élastique conducteur.

9. Dispositif de contact selon l'une des revendications précédentes_{,} caractérisé par le fait qu'au moins une des surfaces de contact affectées au spécimen sur une face de la plaque adaptatrice et la surface de contact associée sur l'autre face de la plaque adaptatrice sont divisées en deux parties isolées l'une de l'autre qui sont reliées électriquement chacune à la partie correspondante située sur l'autre face de la plaque adaptatrice.

10. Dispositif de contact selon l'une des revendications précédentes_{,} caractérisé par le fait que l'élastomère élastique conducteur est un caoutchouc silicone dans lequel sont finement dispersées des particules métallique.
